# EUROPÄISCHE PATENTANMELDUNG

(11) **EP 0 999 725 A2**
(43) Veröffentlichungstag der Anmeldung: **10.05.2000**
(21) Anmeldenummer: 99440293.1
(22) Anmeldetag: 29.10.1999
(51) Int. Cl.: H05B 3/26

(54) **Anordnung zur Erwärmung einer bestückten gedruckten Schaltung**

(30) Priorität: 06.11.1998 DE 19851172
(71) Anmelder: ALCATEL, 75008 Paris (FR)
(72) Erfinder: Friedrich, Carsten, 71634 Ludwigsburg (DE); Jeggle, Norbert, 71672 Marbach (DE)
(74) Vertreter: Brose, Gerhard, Dipl.-Ing.

(57) **Zusammenfassung**

Die Erfindung betrifft eine Anordnung zur Erwärmung einer bestückten gedruckten Schaltung auf eine bestimmte Temperatur. Auf wenigstens einer Oberfläche der gedruckten Schaltung ist zur Wärmeerzeugung eine Mehrzahl von Widerständen angeordnet. Die Widerstände sind in etwa gleichmäßig über die Oberfläche verteilt und sie werden aus einer getrennten Quelle mit elektronischer Energie versorgt.

## Beschreibung

Die Erfindung betrifft eine Anordnung zur Erwärmung einer bestückten gedruckten Schaltung auf eine bestimmte Temperatur. Es gibt elektronische Schaltungen, welche bei einer optimalen Temperatur betrieben werden müssen. Es ist deshalb notwendig, bei diesen elektronischen Schaltungen die Temperatur erforderlichenfalls auf die optimale Temperatur zu erhöhen und die optimale Temperatur beizubehalten.

Eine Möglichkeit, um die elektronische Schaltung zu erwärmen, besteht darin, sie ganz oder teilweise mit einer Heizfolie zu umhüllen. Das hat aber den Nachteil, daß auch andere z.B. mechanische Teile, wie Gehäuse, Schrauben und dergleichen erwärmt werden. Das ist unerwünscht und führt zu einem erhöhten Aufwand.

Das der Erfindung zugrunde liegende technische Problem besteht deshalb darin, eine Methode anzugeben, bei welcher nur die Teile der elektronischen Schaltung erwärmt werden, welche die erforderliche Temperatur aufweisen sollen.

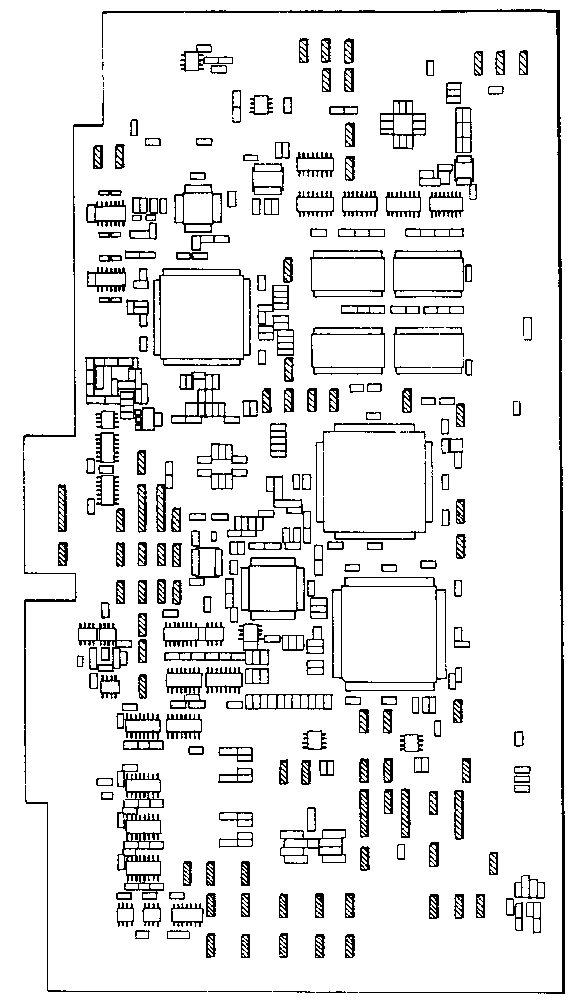

Dieses technische Problem ist erfindungsgemäß dadurch gelöst, daß auf wenigstens einer Oberfläche der gedruckten Schaltung eine Mehrzahl von Widerständen angeordnet ist. Vorteilhafte Einzelheiten der Erfindung sind in den Ansprüchen 2 und 3 enthalten, welche nahestehend anhand eines in der Figur gezeigten Ausführungsbeispiels erläutert ist. Die Figur zeigt die Draufsicht auf eine Oberfläche einer gedruckten Schaltung, beispielsweise einen sogenannten Multilayer, welche mit einer Anzahl von Bauelementen, wie integrierten Schaltungen, Multichipmodulen, bestückt ist. Außer den für den Betrieb der elektronischen Schaltung erforderlichen Widerständen, Kondensatoren und dergleichen ist die gedruckte Schaltung mit einer Mehrzahl von Widerständen, beispielsweise Chipwiderständen, bestückt, welche in der Figur schwarz eingefärbt sind. Diese Widerstände sind in etwa gleichmäßig über die Oberfläche verteilt.

Bei dem gezeigten Ausführungsbeispiel waren auf beiden Oberflächen der gedruckten Schaltung Widerstände, insgesamt 150 Stück mit einem Wert von 3,01 KΩ. Die Versorgung der Widerstände mit elektrischer Energie erfolgt mit zwei getrennten, im Mulitlayer angeordneten Leiterbahnebenen. Bei diesem Ausführungsbeispiel wurden etwa 30 W Wärme erzeugt und es erfolgte eine gleichmäßige Verteilung der Wärme.

## Patentansprüche

1. Anordnung zur Erwärmung einer bestückten gedruckten Schaltung auf eine bestimmte Temperatur,
dadurch gekennzeichnet, daß
auf wenigstens einer Oberfläche der gedruckten Schaltung eine Mehrzahl von Widerständen angeordnet ist.

2. Anordnung nach Anspruch 1, dadurch gekennzeichnet, daß die Spannungsversorgung der Widerstände aus einer getrennten Spannungsquelle erfolgt.

3. Anordnung nach den Ansprüchen 1 und 2, dadurch gekennzeichnet, daß die Spannungsversorgung der Widerstände mit einer Regelung versehen ist.
